(19) Europäisches Patentamt

European Patent Office

Office européen des brevets

(11) **EP 1 043 415 B1**

(12) **EUROPEAN PATENT SPECIFICATION**

(45) Date of publication and mention
of the grant of the patent:
**19.01.2005 Bulletin 2005/03**

(51) Int Cl.[7]: **C22C 29/08**

(21) Application number: **00106691.9**

(22) Date of filing: **29.03.2000**

(54) **Cemented carbide insert**

Sinterkarbideinsatz

Plaquette de carbure frittée

(84) Designated Contracting States:
**AT BE CH CY DE DK ES FI FR GB GR IE IT LI LU
MC NL PT SE**

(30) Priority: **08.04.1999 SE 9901244**

(43) Date of publication of application:
**11.10.2000 Bulletin 2000/41**

(73) Proprietor: **SANDVIK AKTIEBOLAG
811 81 Sandviken (SE)**

(72) Inventors:
• **Lenander, Anders
135 53 Tyreso (SE)**
• **Lindholm, Mikael
126 36 Hägersten (SE)**

(74) Representative: **Taquist, Lennart et al
Sandvik AB
Patent Department
811 81 Sandviken (SE)**

(56) References cited:
**EP-A- 0 697 465         EP-A- 1 026 271
WO-A-93/17140         WO-A-97/09463
WO-A-98/03691         US-A- 4 610 931**

## Description

The present invention relates to a coated cemented carbide cutting tool insert particularly useful for turning operations in steels or stainless steels, especially suited for operations with high demands regarding both toughness and wear resistance properties of the insert. The cemented carbide insert has surface zones with element compositions differing from the bulk composition giving simultaneously an excellent toughness performance and good resistance to plastic deformation.

High performance cutting tools must nowadays possess high wear resistance, high toughness properties and good resistance to plastic deformation. Improved toughness behaviour of a cutting insert can be obtained by increasing the WC grain size and/or by raising the overall binder phase content, but such changes will simultaneously result in significant loss of the plastic deformation resistance.

Methods to improve the toughness behaviour by introducing an essentially gamma phase free and binder phase enriched surface zone with a thickness of about 20-40 μm on the inserts by a so called gradient sintering techniques have been known for some time e. g. US 4,277,283, US 4,497,874, US 4,548,786, US 4,640,931, US 5,484,468, US 5,549,980, US 5,649,279, US 5,729,823. The characteristics of these patents are that the surface zone is depleted of gamma phase and binder phase enriched.

WO-A-97-09463 discloses a coated turning insert with a body consisting of WC, Co and cubic carbides of Ti, Ta and/or Nb and a highly W-alloyed binder phase. The coating includes an innermost layer of $TiC_xN_yO_z$ with columnar grains and a top layer of fine-grained κ-$Al_2O_3$.

EP-A-1043416 discloses a cutting tool insert with a cemented carbide body consisting of WC, 5-12 wt-% Co and 3-11 wt-% of cubic carbides of Ti, Ta and W. The amount of Nb is below 0.1 wt-%, the Ta/Ti ratio 2.0-3.0, and the binder phase is highly alloyed with W. The cemented carbide body has further a 10-30 μm thick, essentially gamma free, surface zone.

It has now surprisingly been found that by using an optimized composition of the gamma phase i.e. a gamma phase consisting essentially of only TaC and TiC in addition to WC, by keeping the ratio between the elements Ta and Ti within specific limits and a W-alloyed binder phase, the toughness properties of the gradient sintered cutting inserts can be significantly improved without any loss of plastic deformation resistance.

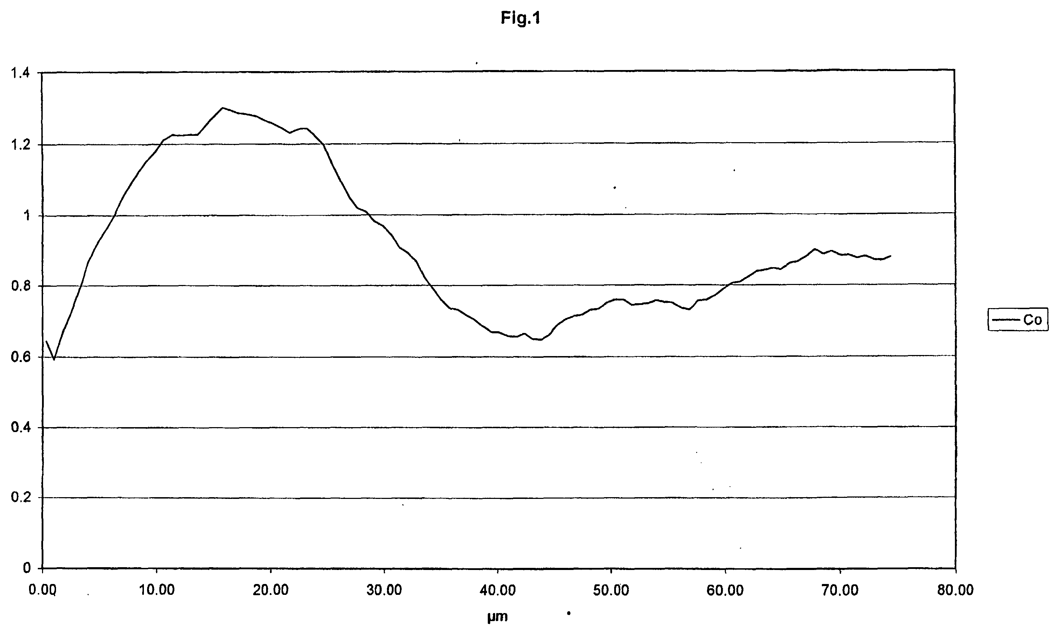

Figure 1 is a plot showing the level of Co enrichment near the surface of an insert according to the invention.

According to the present invention there is now provided a coated cemented carbide insert with a 10-40 μm thick essentially gamma phase free and binder phase enriched surface zone with an average binder phase content (by volume) in the range 1.2-2.0 times the bulk binder phase content. The gamma phase consists essentially of TaC and TiC and to some extent of WC dissolved into the gamma phase during sintering. The ratio Ta/Ti is between 1.0 and 4.0.

The binder phase is highly W-alloyed. The content of W in the binder phase can be expressed as a

$$CW\text{-ratio} = M_s /(wt\text{-}\% \; Co \cdot 0.0161)$$

where

$M_s$ is the measured saturation magnetisation of the cemented carbide body in kA/m and wt-% Co is the weight percentage of Co in the cemented carbide. The CW-ratio takes a value ≤1 and the lower the CW-ratio is the higher is the W-content in the binder phase. It has now been found according to the invention that an improved cutting performance is achieved if the CW-ratio is in the range 0.75-0.95.

The present invention is applicable to cemented carbides with a composition of 6-8.9 weight percent of binder phase consisting of Co, and 3-11, preferably 4-6.9, weight percent TaC + TiC and a balance WC. The Nb content should not exceed 0,1 weight percent. The weight ratio Ta/Ti should be 1.0-4.0. The WC has an average grain size of 1.0 to 4.0 μm, preferably 1.5 to 3.0 μm. The cemented carbide body may contain small amounts, <1 volume-%, of η-phase ($M_6C$).

Inserts according to the invention are further provided with a coating consisting of basically 3-12 μm columnar TiCN-layer followed by a 1-8 μm thick $Al_2O_3$-layer deposited e.g. according to any of the patents US 5,766,782, US 5,654,035, US 5,674,564, US 5,702,808 preferably with a κ-$Al_2O_3$-layer and preferably with an outermost thin layer of TiN which preferably is removed in the edge line by brushing or by blasting.

By applying coatings with different thickness on the cemented carbide body according to the invention, the property of the coated insert can be optimised to suit specific cutting conditions. In one embodiment, a cemented carbide insert produced according to the invention is provided with a coating consisting of: 6 μm TiCN, 5 μm $Al_2O_3$ and 1 μm TiN. This coated insert is particularly suited for operation in steel. In another embodiment, a cemented carbide insert produced according to the invention is provided with a coating consisting of: 8 μm TiCN, 2 μm $Al_2O_3$ and 1 μm TiN. This coating is particularly suited for cutting operations in stainless steels.

Cutting inserts according to the invention comprising a cemented carbide substrate consisting of a binder phase of Co, WC and a gamma phase from the elements Ta and Ti with a binder phase enriched surface zone essentially free of gamma phase and a coating are made in the following way. A powder mixture containing 6-8.9 weight percent of binder phase consisting of Co, and 3-11, preferably 4-6.9, weight percent TaC + TiC and a balance WC with an average grain size of 1.0 - 4.0 µm, preferably 1.5 - 3.0 µm is prepared. The Nb content should not exceed 0.1 weight percent. The weight ratio Ta/Ti should be 1.0-4.0. Well-controlled amounts of nitrogen have to be added either through the powder as carbonitrides or/and added during the sintering process via the sintering gas atmosphere. The amount of added nitrogen will determine the rate of dissolution of the cubic phases during the sintering process and hence determine the overall distribution of the elements in the cemented carbide after solidification. The optimum amount of nitrogen to be added depends on the composition of the cemented carbide and in particular on the amount of cubic phases and varies between 0.6 and 2.0% of the weight of the elements Ti and Ta. The exact conditions depend to a certain extent on the design of the sintering equipment being used. It is within the purview of the skilled artisan to determine whether the requisite surface zone of the cemented carbide have been obtained and to modify the nitrogen addition and the sintering process in accordance with the present specification in order to obtain the desired result.

The raw materials are mixed with pressing agent and possibly W such that the desired CW-ratio is obtained and the mixture is milled and spray dried to obtain a powder material with the desired properties. Next, the powder material is compacted and sintered. Sintering is performed at a temperature of 1300-1500°C, in a controlled atmosphere of about 50 mbar followed by cooling. After conventional post sintering treatments including edge rounding a hard, wear resistant coating according to above is deposited by CVD- or MT-CVD-technique.

Example 1

A.) Cemented carbide turning inserts of the style CNMG 120408-PM with the composition 7,5 wt% Co, 3,8 wt% TaC, 1,9 wt% TiC and 0,40 wt% TiN and balance WC with an average grain size of 2.0 µm were produced according to the invention. The nitrogen was added to the cemented carbide powder as TiCN. Sintering was done at 1450 °C in an atmosphere consisting of Ar at a total pressure of about 50 mbar.

Metallographic investigation showed that the produced inserts had a cubic-carbide-free zone of 25 µm. Fig. 1 shows a plot of the Co enrichment near the surface measured by image analysis technique. Co was enriched to a peak level of 1,3 times the bulk content. Magnetic saturation values were recorded and used for calculating CW-values. An average CW-value of 0.89 was obtained.

After conventional precoating treatment like edge honing, cleaning etc. the inserts were coated in a CVD-process comprising a first coated with a thin layer <1 µm of TiN followed by 6 µm thick layer of TiCN with columnar grains by using MTCVD-techniques (process temperature 850 °C and $CH_3CN$ as the carbon/nitrogen source). In a subsequent process step during the same coating cycle, a 5 µm thick κ-$Al_2O_3$ layer was deposited according to patent US 5,644,564. On top of the κ-$Al_2O_3$ layer a 1,0 µm TiN layer was deposited. The coated inserts were brushed in order to smoothly remove the TiN coating from the edge line.

B.) Cemented carbide turning inserts of the style CNMG 120408-PM with the composition 7,5 wt% Co, 2,9 wt% TaC, 1,9 wt% TiC, 0,5 wt% NbC and 0,40 wt% TiN and balance WC with an average grain size of 2.0 µm were produced. The inserts were sintered in the same process as **A**. Metallographic investigation showed that the produced inserts had a cubic-carbide-free zone of 25 µm. Magnetic saturation values were recorded and used for calculating CW-values. An average CW-value of 0.89 was obtained. The inserts were subject to the same pre-coating treatment as **A,** coated in the same coating process and also brushed in the same way as **A**.

Example 2

Inserts from **A** were tested and compared with inserts from **B** with respect to toughness in a longitudinal turning operation with interrupted cuts.
Material: Carbon steel SS1312.
Cutting data:
Cutting speed =         120 m/min
Depth of cut =       1,5 mm
Feed = Starting with 0,15 mm and gradually increased by 0,10 mm/min until breakage of the edge
Ten edges of each variant were tested
Inserts style: CNMG120408-PM

| Results: | |
| --- | --- |
| | Mean feed at breakage |
| Inserts A | 0,51 mm/rev |
| Inserts B | 0,25 mm/rev |

Example 3

Inserts from **A** and **B** were tested with respect to resistance to plastic deformation in longitudinal turning of alloyed steel (AISI 4340).
Cutting data:

Cutting speed=   160 m/min
Feed=        0,7 mm/rev.
Depth of cut=       2 mm
Time in cut=        0,50 min

The plastic deformation was measured as the edge depression at the nose of the inserts.

| Results: | |
|---|---|
|  | Edge depression, μm |
| Insert A | 61 |
| Insert B | 61 |

Examples 2 and 3 show that inserts A according to the invention exhibit much better toughness in the combination with the same plastic deformation resistance in comparison to inserts B according to prior art.

## Claims

1.    A cutting tool insert for machining of steel comprising a cemented carbide body and a coating wherein said body comprises 6-8.9 wt-% Co, 3-11 wt-% of cubic carbides of metals Ta, Ti and W and balance WC with an average WC-grain size of within 1.0-4.0 μm, with an amount of Nb of less than or equal to 0.1 weight percent, and a nitrogen content of between 0.6 and 2 % of the weight of the elements Ti and Ta,

the ratio Ta/Ti is 1-4, the Co-binder phase is highly alloyed with W with a CW-ratio of 0.75-0.95 defined as

$$\text{CW-ratio} = M_s / (\text{wt-\% Co} \cdot 0.0161)$$

where

$M_s$ is the measured saturation magnetisation of the cemented carbide body in kA/m and wt-% Co is the weight percentage of Co in the cemented carbide and

the cemented carbide body has a binder phase enriched gamma phase free surface zone of a thickness of 10-40 μm with a binder phase content, by volume, of 1.2-2 times the bulk binder phase content.

2.    A cutting tool insert according to claim 1 **characterised in that** the content of TiC and TaC is within 4-6.9 weight percent.

3.    A cutting tool insert according to claims 1 or 2 **characterised in that** said coating comprises a 3-12 μm columnar TiCN-layer followed by a 1-8 μm thick $Al_2O_3$-layer.

4.    A cutting tool insert according to the previous claim **characterised in that** the said $Al_2O_3$-layer is κ-$Al_2O_3$.

5.    A cutting tool insert according to any of claim 3-4 **characterised in** an outermost layer of TiN.

6.    A cutting tool insert according to the previous claim **characterised in that** the TiN layer in the edge line is removed by brushing or by blasting.

## Patentansprüche

1.    Schneidwerkzeugeinsatz für die Stahlbearbeitung mit einem Hartmetallkörper und einer Beschichtung, wobei der Körper 6 bis 8,9 Gew.-% Co, 3 bis 11 Gew.-% kubische Carbide der Metalle Ta, Ti und W, Rest WC, mit einer mittleren WC-Korngröße im Bereich von 1,0 bis 4,0 μm und mit einer Nb-Menge von weniger als oder gleich 0,1 Gew.-% und mit einem Stickstoffgehalt zwischen 0,6 und 2% des Gewichts der Elemente Ti und Ta,

wobei das Verhältnis Ta/Ti 1 bis 4 ist, die Co-Bindephase mit W entsprechend einem CW-Verhältnis von 0,75 bis 0,95 hoch legiert ist, wobei das CW-Verhältnis als

$$\text{CW-Verhältnis} = M_s / \text{Gew.-\% Co. } 0,0161)$$

definiert ist, worin $M_s$ die gemessene Sättigungsmagnetisierung des Hartmetallkörpers in kA/m ist und Gew.-% Co der Gewichtsprozentsatz von Co in dem Hartmetall ist, und der Hartmetallkörper eine mit Bindephase angereicherte, von γ-Phase freie Oberflächenzone einer Dicke von 10 bis 40 μm mit einem Bindephasenvolumengehalt vom 1,2- bis 2-fachen des Gehalts der Bindephasenmasse hat.

2.    Schneidwerkzeugeinsatz nach Anspruch 1, **dadurch gekennzeichnet, daß** der Gehalt an TiC und TaC innerhalb von 4 bis 6,9 Gew.-% liegt.

3.    Schneidwerkzeugeinsatz nach Anspruch 1 oder 2, **dadurch gekennzeichnet, daß** die Beschichtung eine 3 bis 12 μm dicke säulenartige TiCN-Schicht, gefolgt von einer 1 bis 8 μm dicken $Al_2O_3$-Schicht umfaßt.

4.    Schneidwerkzeugeinsatz nach dem vorausgehenden Anspruch, **dadurch gekennzeichnet, daß** die $Al_2O_3$-Schicht κ-$Al_2O_3$ ist.

5.    Schneidwerkzeugeinsatz nach einem der Ansprüche 3 und 4, **gekennzeichnet durch** eine äußerste TiN-Schicht.

6.    Schneidwerkzeugeinsatz nach dem vorausgehenden Anspruch, **dadurch gekennzeichnet, daß** die TiN-Schicht in der Kantenlinie durch Bürsten oder Sandstrahlen entfernt wird.

**Revendications**

1. Plaquette d'outil de coupe pour l'usinage de l'acier comprenant un corps de carbure cémenté et un revêtement, le dit corps comprenant 6 à 8,9% en poids de Co, 3 à 11% en poids de carbures cubiques des métaux Ta, Ti, et W et le reste en WC avec une taille de grain moyen de WC comprise entre 1,0 et 4,0 µm, avec une quantité de Nb inférieure ou égale à 0,1% en poids, et un contenu en azote entre 0,6 et 2% du poids des éléments Ti et Ta,

    le rapport Ta/Ti est de 1 à 4, la phase Co-liant est hautement alliée avec W selon un rapport CW de 0,75 à 0,95 défini comme :

    rapport CW = Ms/(% en poids de Co - 0,0161)

où

    Ms est la magnétisation de saturation mesurée du corps de carbure cémenté en kA/m et % en poids de Co est le pourcentage pondéral de Co dans le carbure cémenté et

    le corps de carbure cémenté a une phase liante enrichie de phase gamma en zone de surface libre d'épaisseur de 10 à 40 µm avec un contenu de phase liante, en volume, de 1,2 à 2 fois le contenu de la phase liante massive.

2. Plaquette d'outil de coupe selon la revendication 1, **caractérisée en ce que** le contenu en TiC et TaC est compris entre 4 et 6,9 pourcent en poids.

3. Plaquette d'outil de coupe selon la revendication 1 ou 2, **caractérisée en ce que** le dit revêtement comprend un couche de TiCN colonnaire de 3 à 12 µm suivie par un couche de $Al_2O_3$ de 1 à 8 µm d'épaisseur.

4. Plaquette d'outil de coupe selon la revendication précédente, **caractérisée en ce que** ledit revêtement $Al_2O_3$ est du $\kappa$-$Al_2O_3$.

5. Plaquette d'outil de coupe selon une quelconque des revendications 3 à 4, **caractérisée par** une couche la plus extérieure en TiN.

6. Plaquette d'outil de coupe selon la revendication précédente, **caractérisée en ce que** la couche de TiN sur l'arrête est enlevée par brossage ou par soufflage.

Fig.1

EP 1 043 415 B1